# EUROPEAN PATENT APPLICATION

(11) **EP 3 719 677 A1**
(43) Date of publication of application: **07.10.2020**
(21) Application number: 19167699.8
(22) Date of filing: 05.04.2019
(51) Int. Cl.: G06F 17/50

(54) **METHOD FOR SCALABLE PARALLEL-COMPUTING OF DESIGN RULE CHECKING (DRC)**

(71) Applicant: Amsimcel Srl, 727605 Vicovu de Jos Suceava (RO)
(72) Inventor: Tugui, Catalin Adrian, 727605 Vicovu de Jos (RO); Dogaru, Emanuel, 601105 Onesti (RO); Donici, Gabriel, 725400 Radauti (RO)

(57) **Abstract**

Processing time of design rule checking (DRC) is identified as one of the most pressing bottlenecks during the design of circuits implemented in modern fabrication technologies that prescribe complex contextual rules for manufacturability.

To address this issue, a method is disclosed that relies on space-partitioning the circuit, thus obtaining a tree-based geometrical representation of the circuit. Operations between geometries encapsulated in nodes belonging to one or multiple trees are shown to be well-suited for parallel processing.

Disclosed are practical techniques that implement such operations on processors with parallel computing capabilities.

Disclosed is an improved DRC method for implementing parallel processing of computing operations by effectively decoupling dependencies between different sequences of computing operations. In a more generic way, this approach may be used to implement parallel processing of time-consuming electronic design automation operations.

A novel DRC method is disclosed that leverages the powerful computing capabilities of current GPUs (Graphic Processor Units). It is shown that, by space-partitioning the circuit, the DRC computation method can be described as a highly parallel formulation which benefits from the GPU parallel computing power. The invention relies on two level of parallelization. Firstly, multiple rules can be executed independently on multiple GPUs. Secondly, each rule is split into many independent simpler tasks that are executed in parallel on the same GPU. This is possible due to the hierarchical representation of the circuit.

It is shown that leveraging parallel computing techniques greatly improves DRC execution times opening the road for real-time execution of DRC on GPUs. Indeed, in one embodiment the GPU implementation of a minimum-distance rule outperforms its single-processor counterpart by two orders of magnitude, achieving real-time design rule checking. Furthermore, the proposed algorithm is scalable to multiple GPUs, can handle multi-billion transistor devices and can accommodate all kind of manufacturing rules needed by the industry.

## Description

### Technical Field

This invention relates to performing design rule checking of integrated circuits, and more particularly to methods for fast and efficient checking of design rules in a circuit layout.

### Background Art

Design rule checking (DRC) is the area of electronic design automation (EDA) that determines whether the physical layout of a particular chip layout satisfies a series of recommended parameters called design rules.

A circuit layout consists of a combination of polygons, each of which is attached to a certain layer. A layer is a conceptual representation of the masks sets used in integrated circuits (IC) manufacturing in order to identify layout levels that are easy to visualize by the circuit designer. The following are layout layers examples: substrates, wells, diffusion regions, polysilicon, metal interconnect, contact and via layers.

The functionality of the circuit is determined by the choice of the layers, as well as the relation between objects on different layers. For instance, an MOS transistor is formed by the cross section of a diffusion layer and a polysilicon layer. An interconnection between two metal layers is formed by a cross section between the two metal layers and an additional contact layer.

The design rule checking of the said layout is done by verifying multiple sets of constraints: intra-layer, inter-layer, connectivity and complex structures constraints.

The intra-layer constraints define the interactions, measurements and connectivity requirements between objects on the same layer, e.g. minimum dimensions of objects on each layer or minimum spacing between objects on the same layer.

The inter-layer constraints define the interactions, measurements and connectivity requirements between objects on multiple layers, e.g. encapsulation dimensions for objects on different layers or minimum spacing between objects on different layers.

The connectivity constraints define layout requirements for the connection of conceptual objects like nets, cells, transistors, resistors, inductors, capacitors, etc.

The complex structures constraints define the layout requirements related to manufacturability of technologies like Fin Field-effect transistor (FinFET), Silicon on insulator (SOI), Silicon-germanium (SiGe), Gallium arsenide (GaAs), three-dimensional integrated circuit (3D IC).

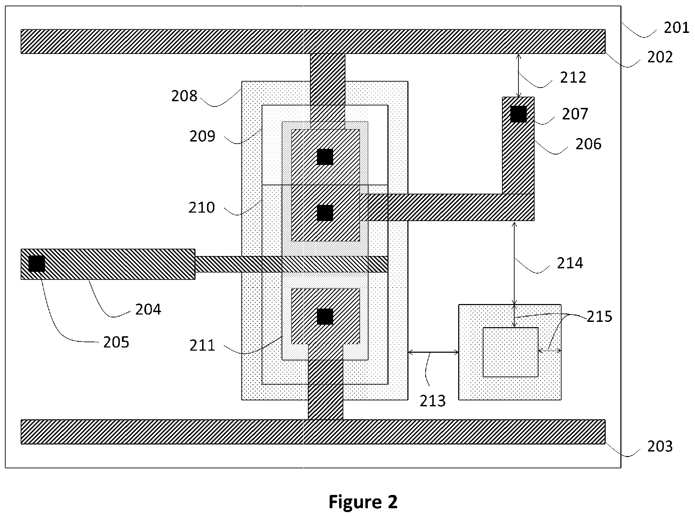

The prior art presented in Figure 2 illustrates graphically the concepts defined previously: In a circuit layout (201) containing multiple layers (e.g. 208, 209, 210) geometrical topologies are defined, representing circuit functionality (e.g. 202 - a supply rail, 203 - a ground rail). This circuit can be connected with other circuits inside an IC, e.g. by means of a contact layer (205) connected to an input (204) and a contact layer (207) connected to an output (206). Circuit elements like transistors, resistors, inductors, capacitors are formed by using multiple layers, where a relation exists between objects on different layers (e.g. 208, 209, 210, 211). An intra-layer constraint represented by 212 defines the minimum distance between geometrical topologies 202 and 206, situated on the same layer. An intra-layer constraint represented by 213 defines the density of geometrical topologies situated on the same layer. An inter-layer constraint represented by 214 defines the minimum distance between geometrical topologies situated on different layers. A connectivity constraint represented by 215 defines an encapsulation requirement of a conceptual object, namely a cell.

All constraints that are characteristic for a certain manufacturing process form a design rule set.

Design rules sets are layout restrictions provided by semiconductor foundries that enable the circuit designer to verify the correctness of the circuit.

A fundamental requirement of the physical layout of a circuit is that it adheres to these design rules. This can be verified by using a design rule checker. Design rule checker means a system that gets as inputs the physical layout of a circuit and descriptions of the design rules presented in the form of a technology file, and provides as output the pass and fail results for each design rule (having enough details to identify the circuit part that is violating).

Advancements in process technology have impacted IC manufacturing in at least two key ways. First, scaling of device geometry achieved through sub-wavelength lithography and multiple patterning has facilitated packing more devices on a chip. Second, different process variants have enabled manufacturing of heterogeneous devices with different threshold and supply voltages on the same die. A consequence of these improvements, however, has been an explosion in the number of design rules that need to be obeyed in the layout. Instead of simple width and spacing rules, modern fabrication technologies prescribe many complex contextual rules that have to be obeyed for manufacturability.

The increase in the number of rules has complicated the task of creating design rule clean layouts, i.e. layouts that do not have design rule violations. Creating design rule clean layouts for digital circuit designs can be facilitated by the use of standard cell layouts as building blocks, and placement and routing tools that are extended to address the design rules. With the advancement in the nanometre scale technologies, place and route tools take very long time due to the complex rules needed to be verified to complete the process.

Furthermore, this approach usually does not work for analogue, RF and custom circuit designs. Layouts for such designs are typically created manually using layout editors, and because of the number and complexity of the design rules, checking them is a laborious process.

The verification of the design rule set of the said layout is executed on computer-aided design rule checking, namely on computer systems with one or multiple processors.

According to the previous definitions DRC is a very computational intensive task as complex circuits can contain billions of polygons that must be checked against each other.

On the other hand, execution time efficiency is the most important property of a good DRC tool. The verification of a large chip can take hours or days of computation time. Both the place and route process and the manual layout editing process is drastically facilitated if design rule checking can be performed in real-time, that is, immediately after each geometric manipulation made by the designer/tool. While some layout editors are able to do this for sub-sets of design rules in larger geometries, the checking can be slow and usually works only when some of the design rules are turned off.

In this context, new EDA verification/validation paradigms are needed, able to keep up with these advances in the design field.

The following patents describe the previous state of the art related to our invention.

U.S. Pat. No. US 5787006 of Chevallier et al. assigned to MICRON TECHNOLOGY for "Apparatus and Method for Management of Integrated Circuit Layout Verification Processes" describes the Design Rule Check (DRC) and Layout Versus Schematic (LVS) verification procedures.

E.P. Pat. No. EP 2728499 A of Berkens assigned to NP KOMPLETE TECHNOLOGIES for "Design rule checking" provides a computer-implemented method for verification of a layout of an integrated circuit according to a design intent with a selected manufacturing process.

U.S. Pat. No. US 8516431 of Yaguchi assigned to NEC INFORMATEC SYSTEMS for "Rule check system, design rule check method and design rule check program" describes a design rule check system which can extract design errors easily.

U.S. Pat. No. US 9798852 of Lei et al. assigned to GLOBALFOUNDRIES Inc. for "Methods of design rule checking of circuit designs" discloses methods for performing design rule checking of a circuit design that benefit routing tools.

U.S. Pat. No. US 5754826 of Gamal et al. assigned to SYNOPSYS for "CAD and Simulation System for Targeting IC Designs to Multiple Fabrication Processes" describes Design Rule Check (DRC) starting with a GDSII file (a polygon level description).

U.S. Pat. No. US 8352887 of Dai et al. assigned to Dai et al. for "High performance design rule checking technique" describes a real time technique for performing Design Rule Check (DRC).

U.S. Pat. No. US 6397373 of Tseng et al. assigned to TAIWAN SEMICONDUCTOR MANUFACTURING COMPANY for "Efficient design rule check (DRC) review system" provides a method and a system for performing a design review checking operation and analysing the resultant data.

U.S. Pat. No. US 7571405 of Aik et al. assigned to ALTERA CORPORATION for "Electrical design rule checking expert traverser system" discloses a method and apparatus for rule checking systems based on a set of predefined or user-defined rules.

U.S. Pat. No. US 8516399 of Paris et al. assigned to Paris et al. for "Collaborative environment for physical verification of microdevice designs" provides a collaborative environment (framework) for physical verification processes on integrated circuit designs.

U.S. Pat. No. US 8612919 of Pikus et al. assigned to Pikus et al. for "Model-based design verification" describes an analogue design-rule-check tool that determines the values of measurements required by the user for occurrences of geometric elements.

U.S. Pat. No. US 2014365532 of Karras et al. assigned to NVIDIA CORPORATION for "BOUNDING VOLUME HIERARCHIES THROUGH TREELET RESTRUCTURING" provides a system, method, and computer program for modifying a hierarchical tree data structure.

U.S. Pat. No. US 8472455 of Aila et al. assigned to Aila et al. for "System and method for traversing a treelet-composed hierarchical structure" provides a method for performing node traversal operations of a treelet-composed hierarchical structure.

### Summary of invention

The aim of this patent is to achieve real-time design rule checking through a scalable parallel-computing method.

We invented a method and algorithm that leverage the powerful parallel computing capabilities of modern graphics processing units (GPU). Indeed, current programmable graphics processing units are highly parallel, multi-threaded, many-cores processors allowing for very fast parallel data processing and very high memory bandwidth. More generically, graphics processing units are well-suited to address problems that can be expressed as data-parallel computations - the same program is executed on many data elements in parallel - with high arithmetic intensity - the ratio of arithmetic operations to memory operations. These are pre-requisites for fast design rule checking of a layout.

We proved that the DRC computation method can be instantiated as a highly parallelizable algorithm which can benefit from the GPU parallel computing power. The Figure 2 and the next summary explain the problem to be addressed by our invention: A circuit layout is composed of multiple masks. Each mask is represented by a layer which is basically a grouping of geometrical topologies. In this context, a design rule is fundamentally a set of constraints between said geometrical figures (part of one or multiple layers). Therefore a design rule algorithm should query the said geometries to verify that the constraints are respected (see Figure 2).

To this aim, the foundation of our invention consists of space partitioning the geometries of each layer in order to create a tree associated to said layer. Space partitioning refers to dividing a space (or in this case a layer) into several regions, and then recursively applying the same space partitioning technique to each of the regions thus created. The obtained regions are organized in a hierarchical tree. Generically speaking, a tree is a data structure defined as a collection of nodes (starting at a root node), where each node is a data structure consisting of data, together with a list of references to nodes (the "children"), with the constraints that no reference is duplicated, and none points to the root. The space partitioning is performed on computer systems with one or multiple processors of type central processing unit (CPU).

The proposed approach has several advantages. First, associating a tree to each layer allows execution of multiple rules in parallel with minimum (see close to none) interaction between processes. Furthermore, having layers structured as trees provides an additional level of parallelization, each operation for each node being executed on parallel threads.

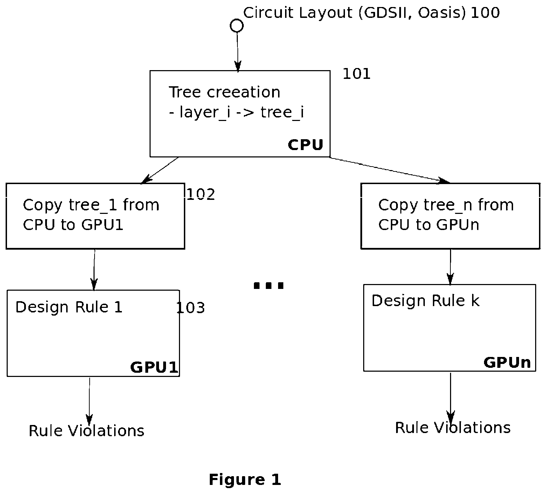

The invented method is represented graphically in Figure 1 and consists of two steps:
1. Constructing a hierarchical generic tree for each layout layer of interest (101)
2. Using the previously created data structures to run DRC algorithms on one or multiple GPUs (103)

The first step (Figure 1, 101) is essential for our invention as it lays the groundwork for running the DRC algorithms in parallel. The step itself consists of creating a hierarchical generic tree by partitioning each layer of interest. There are two major reasons for splitting the layout in multiple independent trees:
- it provides a first level of parallelization, in the sense that multiple rules can be executed on multiple GPUs independently (no data sharing and no synchronization needed)
- it minimizes the memory transfer between the CPU and GPU. Indeed in order to start a design rule on a GPU, one will have to copy to the GPU only that data associated with the layer(s) of interest and not the entire layout. This is a worthy optimization considering that the GPU memory is usually sparser than CPU memory.

### A) Tree composition.

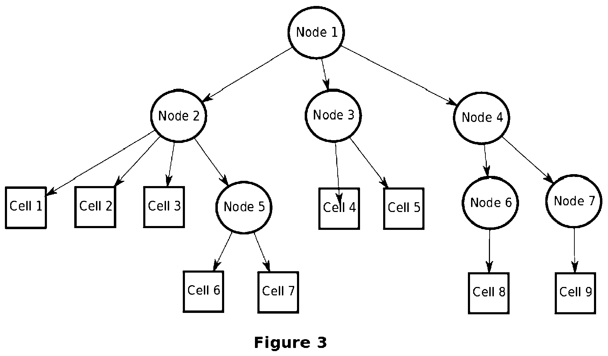

The trees are composed as following (Figure 3). Each node of the tree (represented by a circle) is composed of a list of cells (represented by boxes) and a list of links (or pointers) to its nodes children. Besides that, for each node of the tree we calculate and store the bounding box of the sub-tree underneath. This is for optimization purposes in the DRC algorithms as exemplified later.

Each cell contains a topology represented as a list of rectangles (if dealing with a Manhattan layout) or triangles (for generic polygons). Similarly, each cell has associated a bounding box for optimization purposes.

### B) Tree memory representation.

It is worth noting that due to the large size of the circuits, the trees can grow very fast even for medium sized layouts. This surfaces two major issues.

Firstly, memory allocation is an expensive operation. Allocating memory individually (node by node) for a tree that can easily grow up to millions or even billions of nodes is prohibitively expensive. Moreover, individual allocation will lead to fragmented non-optimized, not localized memory that limits using the entire memory storage efficiently. Secondly, once allocated, the memory has to be copied between the CPU and GPU node by node, which will further increase execution times.

In order to overcome the previous limitations, our method employs a custom memory allocator which has the following responsibilities:
- allocates large blocks of memory at the beginning of the algorithm
- during the creation of the tree, it creates the data (cells, nodes, etc.,) into the pre-allocated memory blocks, taking care that all the information is stored in the same contiguous memory.

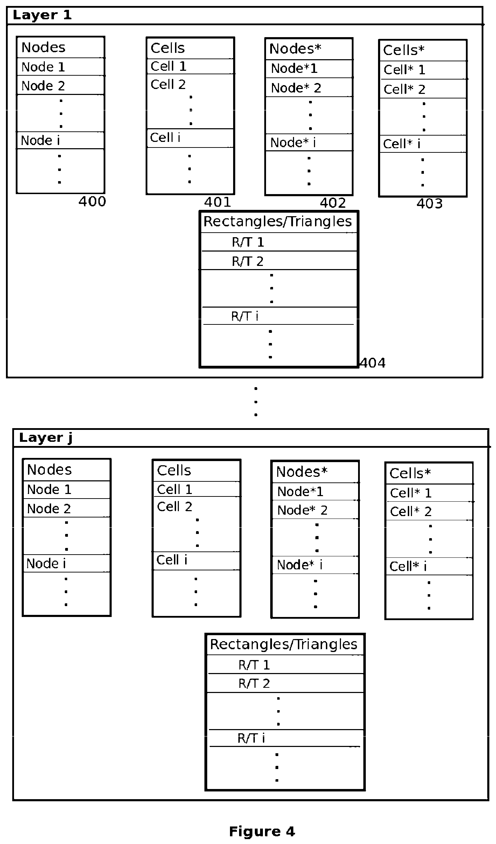

In one embodiment, the C++ implementation of our invention needs only five blocks of contiguous memory to store an entire tree, as represented in Figure 4.

### C) Tree creation.

There are different ways to space partition the layout. However, it is worth to note that a circuit layout is usually generated in a hierarchical form (e.g. the data exchange formats for integrated circuit layout artwork GDSII, OASIS). That is due to the fact that the designer is developing a new functionality by putting together smaller pre-existing blocks. Finally, while there are different ways to partition the layout, the overall architecture of our invention does not change.

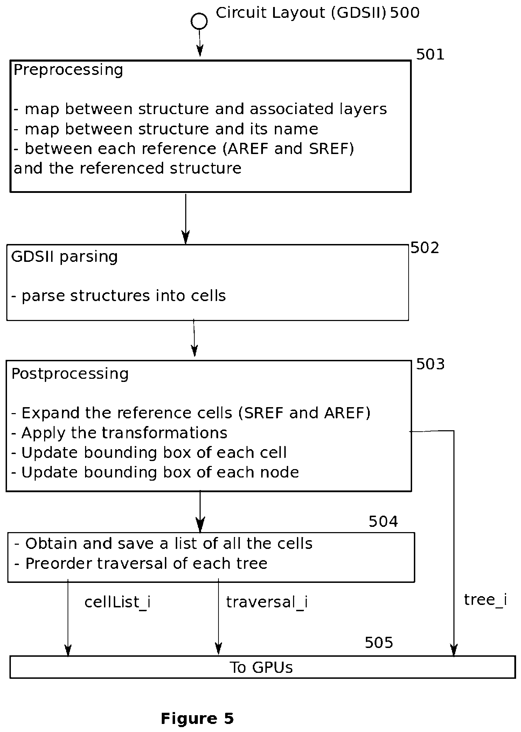

In one embodiment (100), the trees are created from layouts stored in the GDSII stream format stored as a database file format which is the de facto industry standard for data exchange of integrated circuit layout artwork. It contains a hierarchy of structures, each structure containing elements (boundary/polygon, path/polyline, text, box, structure references, and structure array references). The space partition algorithm conserves the hierarchy of the GDSII stream. In one embodiment, the tree creation from a GDSII file is done in three steps as represented in Figure 5:
1) file inspection (501). Due to the organization of the GDSII format (for example, it is valid that a reference to a structure will appear before the structure itself), it is not possible to create the full hierarchical tree at the first passing through the file. Moreover, in order to optimally create a tree for each layer, one has to know layer-related information for each structure. For example, once we parse a structure, we need to know if that respective structure has at least a leaf with its layer id. If not that structure is not added to the tree. To solve this limitation, this first inspection step is considered during which the following information is obtained:
   - A map between each structure and its name.
   - A map between each reference (AREF and SREF) and the referenced structure.
   - A map between each structure and its layers.
2) file parsing (502). During this step, a compact version of each tree is parsed by browsing a second time through the GDSII file. This time the focus is on creating the cells. All the XY records from the Boundary, Path and Box are processed and the lists of rectangles/triangles associated to each structure are obtained.
3) tree post-processing. The final trees for each layer are created as following:
   - Expand the reference (503) cells (SREF and AREF) by recursively copying the referenced nodes
   - Apply the transformations to the newly created nodes
   - Update the bounding box of each cell
   - Update the bounding box of each node.

In one embodiment, the last two steps can be launched on a GPU.

At the same step (504), the following pre-calculations are done for each tree in order to optimize the DRC algorithm:
- Obtain and save a list of all the cells
- Save into a list a Root-Left-Right (pre-order) traversal of the tree. Besides the links to nodes in the tree, the list also contains the size of each sub-tree associated to a node. This list is used to optimize the GPU algorithms by avoiding recursive traversing on the fly. For example, for the tree represented in Figure 3, the following list of pairs is calculated and saved:
   (Node1 -> 6 sub-nodes), (Node2 -> 1 sub-node), (Node5 -> 0 sub-nodes),
   (Node3 -> 0 sub-nodes), (Node4 -> 2 sub-nodes), (Node6 -> 0 sub-nodes),
   (Node7 -> 0 sub-nodes)

### D) Execution of the DRC algorithms on the GPU using the tree created during previous steps.

### Brief description of drawings

Figure 1 shows the overall representation of the invented method.
Figure 2 illustrates the definitions of layout components and design rules.
Figure 3 shows the composition of a hierarchical tree, in one embodiment.
Figure 4 is the graphical representation of the five memory blocks needed to store a tree in one embodiment.
Figure 5 is a computer software sequence for tree generation algorithm.
Figure 6 shows the GPU algorithm to check violations of minimum distance between one cell and its corresponding layer represented by a pre-order traversal.
Figure 7 shows the DRC algorithm comparative execution times on two computing systems for several layouts of different sizes.

### Description of embodiments

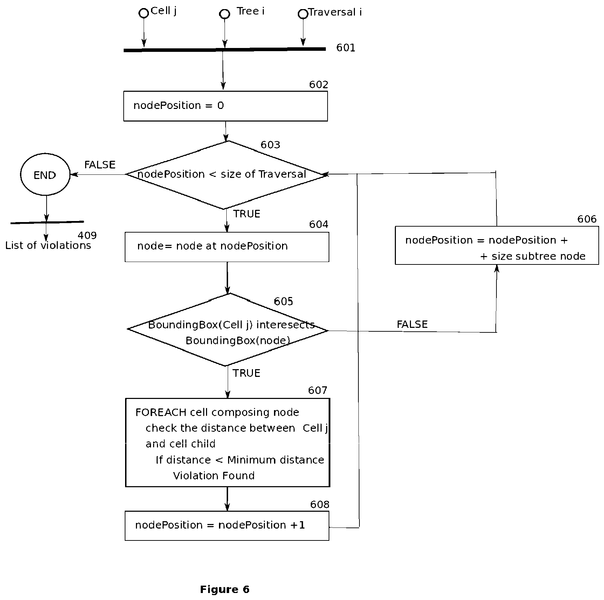

In one embodiment, an intra-layer minimum spacing distance was implemented (Figure 6). The goal of the rule is to check that a minimum distance between any two cells inside a layer is respected. To this aim, the algorithm uses only the tree associated to the layer and the corresponding list of cells and tree traversal.

Each thread of the GPU is in charge of checking the minimum distance between one cell from the list of cells and the rest of the layer defined by its tree traversal according to the algorithm represented graphically in Figure 6. This provides a second level of parallelization as discussed previously.

Efficient minimum distance checking is done by expanding the boundary for the cell of interest at all sides and then querying to find all intersecting cells. Nonetheless, having the layout spaces partitioned comes with an important optimization opportunity; that is if a cell does not intersect with a region (represented by a node in the tree) then the said cell will not intersect any of the cells associated to the said region.

Intersection between a cell (expanded by the minimum distance parameter) and any other cell from the tree is verified as following (Figure 6):
- first check if the bounding box of the cell intersects the bounding box of the root (605). If this is not the case, it means that the cell does not intersect any of the cells in the sub-tree associated to the said root and that specific sub-tree can be further ignored from the verification. The capability to skip an entire sub-tree is given by the fact that the tree traversal contains information about the size of each sub-tree (606).
- if the bounding boxes intersect then check the intersection between the current cell and all the cells associated to the current root. Move to the next node in the traversal and start over this algorithm (608)
- the intersection between two cells is done by first checking if their bounding boxes intersect and if this is the case by checking intersection between every rectangle/triangle in the first cell with every rectangle/triangle in the second cell

In one embodiment, we used the proposed method to perform the design rule checking of several circuits layouts of different sizes. The same algorithm has been computed on one computing system composed with one CPU with parallel computing capabilities (1) and on a heterogeneous computing system composed with one CPU with parallel computing capabilities and one GPU with parallel computing capabilities (2).

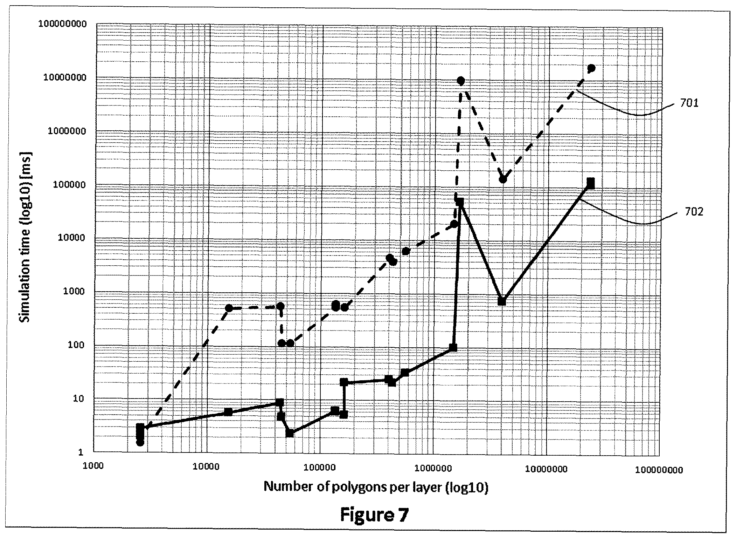

The design rule checked in this particular embodiment is the minimum spacing distance between geometries composing vias in a metallization layout layer. The computer simulation times are provided comparatively in Figure 7. The figure represents the simulation time used by one computing systems to verify the design rule (on the logarithmic OY axis) versus layout size. The computer simulations are performed independently for both systems and then compared.

The graph 701 represents the punctual simulation times achieved by the said CPU-based computing system (1) for 18 layouts with the number of polygons in the range [2000; 30000000] together with the linear approximation for the inter-point intervals.

The graph 702 represents the punctual simulation times achieved by the said heterogeneous computing system (2) for the same 18 layouts together with the linear approximation for the inter-point intervals.

The general observable trend when comparing the graph 701 with 702 is that the said heterogeneous computing system (2) achieves consistently smaller (better) simulation times when compared to the said CPU-based computing system (1) for layout sizes larger than 10000 polygons.

The next table provides comparatively the simulation times for 3 layouts on both systems and the normalized speed-up in simulation between the said heterogeneous computing system (2) and the said CPU-based computing system (1).

**Table 1 Simulation times comparison for one embodiment**

| Layout# layer size (number of polygons) | Simulation time computing system (1) [ms] | Simulation time computing system (2) [ms] | Simulation speed-up (2) vs. (1) |
|---|---|---|---|
| 15572 | 509.08 | 5.73 | 88x |
| 1490425 | 20090.8 | 99.215 | 202x |
| 23915520 | 17118200 | 130311 | 131x |

According to the results presented on column 4 of table, namely Simulation speed-up (2) vs. (1): the simulation speed-up is between one order of magnitude to more than two orders of magnitude between the said CPU-based computing system (1) and the said heterogeneous computing system (2). This speed-up coupled with simulation times of the orders of milliseconds to seconds makes it possible to achieve real-time design rule checking using the invented method in the proposed system (2).

The trend shown by this embodiment underlines the general trend for all design rules and all heterogeneous computing systems composed with any number of CPUs with parallel computing capabilities and any number of GPUs with parallel computing capabilities: the invented techniques achieve real-time design rule checking through a scalable parallel-computing method.

### Industrial applicability

This invention is directly applicable in the field of semiconductor devices manufacturing based on the detailed descriptions in the summary of invention and embodiments.

With relation to the methods of performing design rule checking of integrated circuits prior to manufacturing, the invented method supports design rule sets that include but are not limited to:
- Active to active spacing
- Well to well spacing
- Minimum channel length of the transistors
- Minimum metal width
- Metal to metal spacing
- Metal fill density
- Poly density
- Dummy fill
- Multiple patterning
- Fin Field-effect transistor (FinFET) specific rules
- Silicon on insulator (SOI) specific rules
- Silicon-germanium (SiGe) specific rules
- Gallium arsenide (GaAs) specific rules
- Three-dimensional integrated circuit (3D IC) specific rules

The method encompasses also providing DRC fix suggestions when violations are identified.

The method handles both very large flat designs and very large hierarchical designs by using different space-partitioning techniques.

While this invention has been described in terms of the above specific embodiment(s), those skilled in the art will recognize that the invention can be practiced with modifications within the spirit and scope of the appended claims, i.e. that changes can be made in form and detail, without departing from the spirit and scope of the invention. Accordingly all such changes come within the purview of the present invention and the invention encompasses the subject matter of the claims which follow.

## Claims

1. A method for scalable parallel-computing of design rule checking comprising: having a circuit layout (represented as an union of layers); having a specified set of design rules; inspecting the said layout to process information associated to the layers, the geometrical topologies and their geometrical relations; space-partitioning the said layout in order to create a tree or a set of trees associated to said layout; checking each design rule from the specified set independently on one or multiple processors with parallel computing capabilities.

2. The method of claim 1, wherein multiple space partitioning methods can be used to construct a generic hierarchical tree for each layer.

3. The method of claim 2, wherein each node of the tree is composed of a list of cells and a list of references to its children nodes.

4. The method of claim 3, wherein each cell contains a polygonal topology represented as a union of rectangles/triangles.

5. The method of claim 2, wherein each tree resides in contiguous blocks of memory: the trees are pre-computed on one processor and stored in the said blocks of memory; when the parallel processors share the same said memory, the blocks of memory are directly accessed by all processors; when the parallel processors do not share the same said memory, the blocks of memory are moved in a single memory transfer.

6. The method of claim 1, further comprising pre-calculating tree traversals: using the said tree traversals to compute the design rule checking for every node in case of intra-layer rules; using the said tree traversals to compute the design rule checking for pairs of nodes in case of inter-layer, connectivity and complex structures rules; using the said tree traversals to optimize the design rule checking by avoiding recursion.

7. The method of claim 1, further comprising pre-calculating a sorted list of cells for each tree: using the said list of cells to distribute the tasks on all of the processors' threads; using the said list of cells such that every thread computes a task independently of the rest of threads.

8. The method of claim 1, wherein each design rule is checked independently: on one processor with parallel computing capabilities using information stored in its associated tree; on multiple processors with parallel computing capabilities in case the associated tree is too large. In this case the tree is split into multiple sub-trees.

9. The method of claim 8, wherein multiple design rules are checked in parallel on multiple processors with parallel computing capabilities.

10. The method of claim 8, wherein each rule is executed in parallel on multiple threads of the processor(s), each thread having the ownership of a single cell from the pre-calculated list of cell.

11. The method of claim 10, further comprising an embodiment where the said processor is a Graphical Processor Unit (GPU).

12. The method of claim 8, further comprising an embodiment to execute design rule checking for violations of minimum distance between cells of the same layer: having a circuit layout in the GDSII format; using the GDSII hierarchical representation to space-partition the circuit.

13. The method of claim 8, further comprising an embodiment to execute design rule checking for violations of minimum distance between cells of two layers.

14. The method of claim 12, wherein the minimum distance between a cell and the rest of the layer is verified by employing the pre-calculated tree traversal; each thread of the processor with parallel computing capabilities verifies the distance between one cell and the rest of the layer.

15. The method of claim 1, further comprising an embodiment where the said method is implemented on heterogeneous computing systems composed of several CPUs and several GPUs.
